# EUROPEAN PATENT APPLICATION

(11) **EP 1 777 713 A2**
(43) Date of publication of application: **25.04.2007**
(21) Application number: 06255336.7
(22) Date of filing: 17.10.2006
(51) Int. Cl.: H01G 4/12

(54) **Barium titanate based dielectric precursor solution comprising barium acetate for capacitor**

(30) Priority: 21.10.2005 US 729426 P
(71) Applicant: E.I. du Pont de Nemours and Company, Wilmington, DE 19898 (US)
(72) Inventor: Borland, William J., Cary, North Carolina 27513 (US); Maria, Jon-Paul, Raleigh, North Carolina 27606 (US); Ihlefeld, Jon Frederick, Raleigh, North Carolina 27606 (US)
(74) Representative: Towler, Philip Dean

(57) **Abstract**

Disclosed are high permittivity (dielectric constant), thin film CSD barium titanate based dielectric precursor solution comprising barium acetate, a titanium source and a B site cation source. The dielectrics show capacitance as a function of temperature that better satisfies the X7R requirements. A method of making a capacitor with this barium titanate based dielectric precursor solution is disclosed.

## Description

### TECHNICAL FIELD

The present invention pertains to thin film capacitors, more particularly to thin film capacitors formed on copper foil that can be embedded in printed wiring boards (PWB) to provide capacitance for decoupling and controlling voltage for integrated circuit die that are mounted on the printed wiring board package.

### RELATED ART

As semiconductor devices including integrated circuits (IC) operate at higher frequencies, higher data rates and lower voltages, noise in the power and ground (return) lines and supplying sufficient current to accommodate faster circuit switching becomes an increasingly important problem requiring low impedance in the power distribution system. In order to provide low noise, stable power to the IC, impedance in conventional circuits is reduced by the use of additional surface mount technology (SMT) capacitors interconnected in parallel. The higher operating frequencies (higher IC switching speeds) mean that voltage response times to the IC must be faster. Lower operating voltages require that allowable voltage variations (ripple) and noise become smaller. For example, as a microprocessor IC switches and begins an operation, it calls for power to support the switching circuits. If the response time of the voltage supply is too slow, the microprocessor will experience a voltage drop or power droop that will exceed the allowable ripple voltage and noise margin and the IC will trigger false gates. Additionally, as the IC powers up, a slow response time will result in power overshoot. Power droop and overshoot must be controlled within allowable limits by the use of capacitors that are close enough to the IC that they provide or absorb power within the appropriate response time.

Capacitors for decoupling and dampening power droop or overshoot are generally placed as close to the IC as possible to improve their performance. Conventional designs have capacitors surface mounted on the printed wiring board (PWB) clustered around the IC. In this case, large numbers of capacitors requires complex electrical routing which leads to increased inductance. As frequencies increase and operating voltages continue to drop, power increases and higher capacitance has to be supplied at increasingly lower inductance levels. A solution would be to incorporate a high capacitance density, thin film ceramic capacitor in the PWB package onto which the IC is mounted. A single layer ceramic capacitor directly under the IC reduces the inductance to as minimum as possible and the high capacitance density provides the capacitance to satisfy the IC requirements. Such a capacitor in the PWB can provide capacitance at a significantly quicker response time and lower inductance.

The concept of embedding ceramic capacitor films in printed wiring boards is known. Capacitors are initially formed on metal foils by depositing a capacitor dielectric material on the foil and annealing it at an elevated temperature. A top electrode is formed on the dielectric to form a fired capacitor-on-foil structure. The foil is then bonded to an organic laminate structure to create an inner layer panel wherein the capacitor is embedded in the panel. These inner layer panels are then stacked and connected by interconnection circuitry, the stack of panels forming a multilayer printed wiring board.

A high capacitance density capacitor can be achieved by use of a dielectric with a high permittivity or dielectric constant (K) and a thin dielectric. High permittivity dielectrics are well known in ferroelectric ceramics. Ferroelectric materials with high permittivities include perovskites of the general formula ABO₃ in which the A-site and B-site can be occupied by one or more different metals. For example, high K is realized in crystalline barium titanate (BT), lead zirconate titanate (PZT), lead lanthanum zirconate titanate (PLZT), lead magnesium niobate (PMN) and barium strontium titanate (BST) and these materials are commonly used in surface mount component devices. Barium titanate based compositions are particularly useful as they have high dielectric constants and they are lead free.

Thin-film capacitor dielectrics with a thickness of less than 1 micron are known. Thin films can be deposited on to a substrate by sputtering, laser ablation, chemical vapor deposition, and chemical solution deposition. Initial deposition is either amorphous or crystalline depending upon deposition conditions. Amorphous compositions have low K (approximately 20) and have to be annealed at high temperatures to induce crystallization and produce the desired high K phase. The high K phase in barium titanate based dielectrics can only be achieved when grain sizes exceed approximately 0.1 µm and so annealing temperatures as high as 900°C may be used.

Chemical solution deposition (CSD) techniques are commonly used to form thin film capacitors on metal foils. CSD techniques are desirable due to their simplicity and low cost.

A barium titanate CSD composition is disclosed in U.S. Patent 7,029,971 to Borland et al. The composition is particularly suitable for forming high permittivity, thin ceramic films on copper foil. The precursor composition consists of the following chemicals:

| | |
|---|---|
| Barium acetate | 2.6 g |
| Titanium isopropoxide | 2.9 ml |
| Acetylacetone | 2.0 ml |
| Acetic acid | 10.0 ml |
| Methanol | 15 ml |

After annealing at 900°C in a partial pressure of oxygen of approximately 10⁻¹¹ atmospheres (1.01 x 10⁻⁶ Pa), the capacitors may be re-oxidized for 30 minutes at approx. 550°C in an oxygen partial pressure of approx. 10⁻⁸ atmospheres. The dielectric thus formed, has a high permittivity and capacitors exhibit high capacitance. The Curie point of the dielectric (the temperature at which the dielectric shows its maximum capacitance) is at approximately 120°C and the dielectric shows a relatively large change in capacitance over the temperature range of -55°C to 125°C. This results in capacitance that varies too greatly as a function of temperature for use in a majority of applications.

### SUMMARY

According to a first embodiment, high permittivity (dielectric constant), thin film CSD barium titanate based dielectric compositions that have titanium partially substituted by zirconium, tin or hafnium, are disclosed. The compositions show lower Curie point temperatures and capacitance as a function of temperature that better satisfies the requirements of a change in capacitance limited to +/- 15% from its value at 25°C in the range -55°C to 125°C, or X7R characteristics.

Capacitors constructed according to the above method can be embedded into inner-layer panels, which may in turn be incorporated into printed wiring boards. The capacitors have high capacitance, low loss tangents, and acceptable capacitance versus temperature characteristics.

Those skilled in the art will appreciate the above stated advantages and other advantages and benefits of various additional embodiments of the invention upon reading the following detailed description of the embodiments with reference to the below-listed drawings.

According to common practice, the various features of the drawings discussed below are not necessarily drawn to scale. Dimensions of various features and elements in the drawings may be expanded or reduced to more clearly illustrate the embodiments of the invention.

### BRIEF DESCRIPTION OF THE DRAWINGS

The detailed description will refer to the following drawings, wherein like numerals refer to like elements, and wherein:
FIG. 1 is a block diagram illustrating a process for preparing a precursor solution used to form a dielectric that contains zirconium, tin or hafnium partially substituting for titanium in barium titanate.
FIG. 2 is a block diagram illustrating a process for making a capacitor on copper foil.
   Tables 1, 2 and 3 contain formulas for the zirconium, tin and hafnium containing compositions.
FIG. 3 is a graph showing relative permittivity (dielectric constant) and loss tangent (dissipation factor) as a function of electric field for pure barium titanate and compositions of barium titanate with varying amounts of barium zirconate.
FIG. 4 is a graph showing relative permittivity (dielectric constant) as a function of temperature for pure barium titanate and compositions of barium titanate with varying amounts of barium zirconate.
FIG. 5 is a graph showing relative permittivity as a function of temperature for pure barium titanate showing the X7R region.
FIG. 6 is a graph showing relative permittivity as a function of temperature for 95% barium titanate 5% barium zirconate showing the X7R region.
FIG. 7 is a graph showing relative permittivity as a function of temperature for 90% barium titanate 10% barium zirconate showing the X7R region.
FIG. 8 is a graph showing relative permittivity as a function of temperature for 75% barium titanate 25% barium zirconate showing the X7R region.
FIG. 9 is a graph showing relative permittivity (dielectric constant) and loss tangent (dissipation factor) as a function of electric field for pure barium titanate and compositions of barium titanate with varying amounts of barium stannate.
FIG. 10 is a graph showing relative permittivity (dielectric constant) as a function of temperature for pure barium titanate and compositions of barium titanate with varying amounts of barium stannate.
FIG. 11 is a graph showing relative permittivity as a function of temperature for 95% barium titanate 5% barium stannate showing the X7R region.
FIG. 12 is a graph showing relative permittivity as a function of temperature for 90% barium titanate 10% barium stannate showing the X7R region.
FIG. 13 is a graph showing relative permittivity as a function of temperature for 75% barium titanate 25% barium stannate showing the X7R region.
FIG. 14 is a graph showing relative permittivity (dielectric constant) and loss tangent (dissipation factor) as a function of electric field for pure barium titanate and compositions of barium titanate with varying amounts of barium hafnate.
FIG. 15 is a graph showing relative permittivity (dielectric constant) as a function of temperature for pure barium titanate and compositions of barium titanate with varying amounts of barium hafnate.
FIG. 16 is a graph showing relative permittivity as a function of temperature for 95% barium titanate 5% barium hafnate showing the X7R region.
FIG. 17 is a graph showing relative permittivity as a function of temperature for 90% barium titanate 10% barium hafnate showing the X7R region.
FIG. 18 is a graph showing relative permittivity as a function of temperature for 75% barium titanate 25% barium hafnate showing the X7R region.

### DETAILED DESCRIPTION

High capacitance density thin-film barium titanate based dielectrics with titanium partially substituted by zirconium (Zr), hafnium (Hf), and tin (Sn) are disclosed.

The barium titanate based thin-film dielectrics with titanium partially substituted by zirconium, hafnium or tin according to the present invention, may exhibit high permittivities (dielectric constant), lower Curie point temperatures and a relatively stable capacitance versus temperature characteristic that better satisfies X7R requirements.

The present invention discloses a barium titanate-based dielectric precursor solution comprising barium acetate, a titanium source and a B-site cation source. In one embodiment, the titanium source is selected from titanium isopropoxide, titanium butoxide, and mixtures thereof. In one embodiment, the B-site cation source is selected from zirconium propoxide, tin butoxide, tetrakis(1-methoxy-2-methyl-2-propoxy)hafnium(1V), and mixtures thereof.

In a further embodiment, the zirconium propoxide is partially or fully replaced by one or more zirconium sources selected from zirconium (IV) t-butoxide, zirconium acetate, tetrakis (ethymethylamido) zirconium, tetrakis (triethanolaminato) zirconium, tetrakis (dimethylamido) zirconium (IV), zirconium (IV) acetylacetonate, and zirconium (IV) isopropoxide isopropanol. In a further embodiment, the tin butoxide propoxide is partially or fully replaced by one or more tin sources selected from tin (IV) isopropoxide, tin (II) 2-ethylhexanoate, tetrabutlytin, tetramethyltin and tetraphenyltin. In a further embodiment, the tetrakis(1-methoxy-2-methyl-2-propoxy)hafnium(IV) is partially or fully replaced by one or more hafnium sources selected from hafnium tert-butoxide, tetrakis (ethymethylamido) hafnium (IV), and tetrakis (dimethylamido) hafnium (IV).

The present invention also discloses a barium titanate dielectric composition for fired on foil capacitors comprising barium titanate and one or more barium-based compounds selected from barium zirconate, barium stannate and barium hafnate. In a further embodiment of the dielectric composition, the barium titanate is present in the range of 90-95 mole percent, based on total composition and wherein said barium-based compounds are present in the range of 5-10 mole percent, based on total composition.

A further embodiment of the present invention provides a method of making a capacitor, comprising: providing a bare metallic foil; forming a dielectric over the bare metallic foil, wherein forming the dielectric comprises: providing a dielectric precursor solution comprising barium acetate, at least one of titanium isopropoxide and titanium butoxide, and a B-site cation source selected from zirconium propoxide, tin butoxide, tetrakis(1-methoxy-2-methyl-2-propoxy)hafnium(IV), and mixtures thereof; forming a dielectric layer over the foil; annealing the dielectric layer; wherein annealing comprises: annealing at a temperature in the range of about 800-1050°C and annealing comprises annealing in an environment having an oxygen partial pressure of less than about 10⁻⁸ atmospheres (1.01 x 10⁻³ Pa); re-oxygenating the dielectric resulting from the annealing; and forming a conductive layer over the dielectric, wherein the metallic foil, the dielectric, and the conductive layer form the capacitor. Additionally, the present invention discloses capacitor formed by the method above.

BaTiO₃ is a preferred core material in the formation of high capacitance density dielectrics according to the present invention. However, the Zr, Hf, and Sn may be used to partially substitute for titanium to shift the Curie point of the dielectric to lower temperatures and to broaden the temperature dependence of capacitance at the Curie point in the dielectric.

The capacitor embodiments discussed herein have a physically robust dielectric thickness in the range of about 0.6-1.0 µm and those that better satisfy X7R requirements have relative permittivities between 500 and 1500.

Chemical solution deposition (CSD) techniques may be used to form the dielectric. CSD techniques are desirable due to their simplicity and low cost. The chemical precursor solution from which BaTiO₃ based dielectrics are prepared preferably comprise barium acetate, titanium isopropoxide, and a valance 4 cation source chosen from zirconium propoxide, tin butoxide, and tetrakis(1-methoxy-2-methyl-2-propoxy)hafnium(IV).

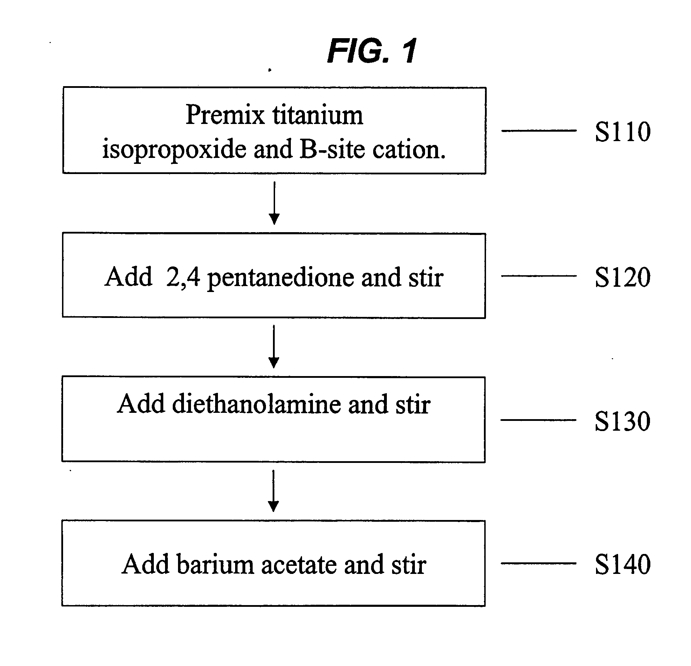

**FIG. 1** is a block diagram illustrating a process for preparing a precursor solution that will be used to form a dielectric according to the present invention. In step **S110,** titanium isopropoxide and the appropriate B-site cation, chosen from zirconium propoxide, tin butoxide, or tetrakis(1-methoxy-2-methyl-2-propoxy)hafnium(IV), are mixed together and stirred. In step **S120**, 2,4 pentanedione is added to the mixture and the solution is stirred at room temperature. The premix can be done in, for example, a PYREX^{®} container. In step **S130,** diethanolamine is added to the Ti isopropoxide/B-site cation/2,4 pentanedione mixture. In step **S140,** a solution of barium acetate and acetic acid is added into the container, and stirred. Variants of the acetic acid and titanium isopropoxide in the above-described precursor solution may also be used. For example, acetic acid may be substituted with methanol, ethanol, isopropanol, butanol and other alcohols. Titanium isopropoxide may also be substituted by titanium butoxide. Additionally, other variants for the zirconium, tin or hafnium sources may be used. For example, tin (IV) isopropoxide, tin (II) 2-ethylhexanoate, tetrabutlytin, tetramethyltin or tetraphenyltin may be substituted for tin butoxide. Zirconium (IV) t-butoxide, zirconium acetate, tetrakis (ethymethylamido) zirconium, tetrakis (triethanolamiinato) zirconium, tetrakis (dimethylamido) zirconium (IV), zirconium (IV) acetylacetonate, or zirconium (IV) isopropoxide isopropanol complex may be substituted for zirconium propoxide. Finally, hafnium tert-butoxide, tetrakis (ethymethylamido) hafnium (IV), tetrakis (dimethylamido) hafnium (IV) may be substituted for the tetrakis (1-methoxy-2-methyl-2-propoxy) hafnium (IV). Other variants may also be possible. The specific chemicals used in the formulas corresponding to the compositions used in the examples contained herein are shown in **Tables 1, 2,** and **3.**

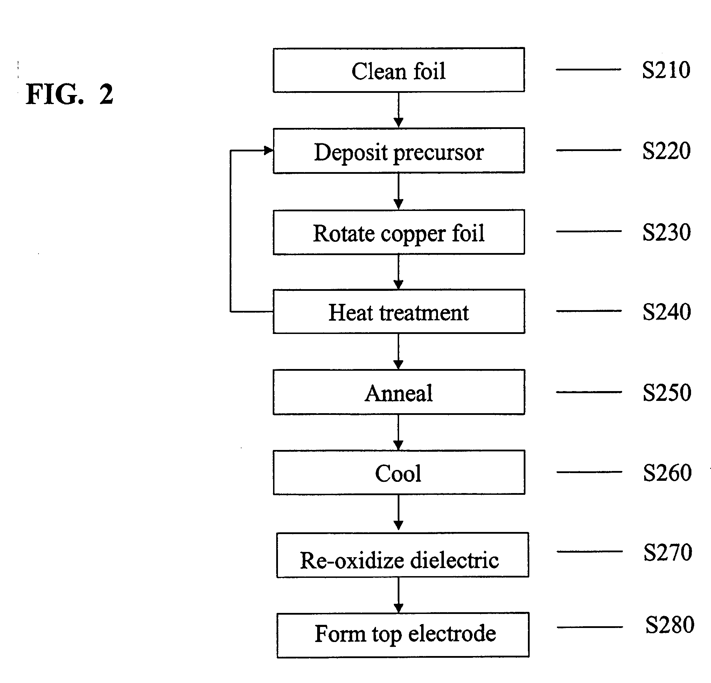

**FIG. 2** is a block diagram of a method suitable for forming a capacitor according to the present invention. The dielectric of the resultant capacitor may be formed using the precursor solution discussed above with reference to **FIG. 1.**

The deposition process illustrated in **FIG. 2** is spin coating. Other coating methods, such as dip or spray coating, are also feasible. In step **S210,** a metallic foil may be cleaned. Cleaning is not always necessary but may be advisable. The metallic foil may be made from copper. Copper foils are desirable due their low cost and ease of handling. The copper foil will serve as a substrate on which a capacitor is built. The copper foil also acts as a capacitor "bottom" electrode in the finished capacitor. In one embodiment, the substrate is an 18 µm thick electroless, bare copper foil. Other untreated foils, such as 1 oz (28.3 g) copper foil, are also suitable. Suitable cleaning conditions include etching the foil for 30 seconds in a dilute solution of copper chloride in hydrochloric acid. The etching solution may be diluted approximately 10,000 times from its concentrated form. The cleaning process removes the excess oxide layer, fingerprints and other accumulated foreign matter from the foil. If the copper foil is received from a vendor or other source in a substantially clean condition, and is handled carefully and promptly used, the recommended cleaning process may not be necessary.

The copper foil is preferably not treated with organic additives. Organic additives are sometimes applied in order to enhance adhesion of a metallic substrate to epoxy resins. Organic additives, however, may degrade the dielectric film during is deposited over the drum side (or "smooth side") of the copper foil substrate. The precursor solution may be applied using, for example, a plastic syringe.

In step **S230**, the substrate is rotated for spin coating. A suitable rotation time and speed are 30 seconds at 3000 revolutions per minute. In step **S240**, the substrate is heat-treated. Heat treatment may be performed, for example, at a temperature of 250°C for two to ten minutes. Heat treatment is used to dry the precursor solution by evaporating solvents in the precursor solution. Consecutive spinning steps may be used to coat the foil substrate to the desired thickness. Five spinning steps, for example, may be used to produce a final dried dielectric precursor thickness of 0.5-1 µm.

In step **S250**, the coated substrate is annealed. Annealing first removes residual organic material, and then sinters, densifies and crystallizes the dried dielectric precursor. Annealing may be conducted in a high temperature, low oxygen partial pressure environment. A suitable total pressure environment is about 1 atmosphere. A suitable oxygen partial pressure is about 10⁻¹⁰ to 10⁻¹¹ atmospheres (1.01 x 10⁻⁵ - 1.01 x 10⁻⁶ Pa).

In step **S250,** the low oxygen partial pressure may be achieved by bubbling high purity nitrogen and small quantities of forming gas through a controlled temperature water bath. Other gas combinations are also possible. In one embodiment, the furnace temperature is at least about 900°C, and the oxygen partial pressure is approximately 10⁻¹¹ atmospheres (1.01 x 10⁻⁶ Pa). The water bath may be at a temperature of about 25°C. The annealing can be performed by inserting the coated foil substrate into a furnace at temperatures below 250°C. The furnace is then ramped up to 900°C at a rate of about 30°C/minute. The furnace is maintained at 900°C for approximately 30 minutes.

In step **S260**, the foil substrate is allowed to cool. Cooling may be governed by a Newtonian profile, for example, created by simply switching the furnace off. Alternatively, the furnace temperature may be ramped down at a specific rate. When the furnace temperature reaches about 450°C, the foil substrate may be safely removed from the furnace without risk of undesired oxidation effects on the copper foil. Alternatively, the furnace may be allowed to return to room temperature before the foil substrate is removed from the furnace.

In the low oxygen partial pressure annealing process, the copper foil is not oxidized to Cu₂O or CuO. This resistance to oxidation is due to the low oxygen pressure and high processing temperature.

In step **270**, the dielectric may be re-oxidized by placing the foil in a vacuum chamber under an atmosphere of approximately 10⁻⁸ Torr (1.33 x 10⁻⁶ Pa) of oxygen at 550°C for 30 minutes. Alternatively, re-oxidation may be achieved by heating the sample in flowing reagent grade nitrogen (1 ppm oxygen) at 550°C for about 30 minutes. In step **280**, top electrodes are formed over the resulting dielectric. The top electrode can be formed by, for example, sputtering, evaporation, chemical vapor deposition, electroless plating, printing or other suitable deposition methods. In one embodiment, sputtered 200 µm diameter platinum electrodes are used. Other suitable materials for the top electrode include nickel, copper, gold and palladium. The top electrodes may be plated with copper to increase thickness, if desired.

The high temperature annealing of 900°C described above for densification and crystallization of the deposited dielectric provides desirable physical properties and desirable electrical properties. One desirable physical property is a dense microstructure. Another desirable physical property is resultant grain sizes between 0.05 µm and 0.2 µm. One desirable electrical property resulting from the grain size and the valence 4 cation substitution is a high permittivity (dielectric constant) in excess of 600 with capacitance - temperature characteristics that better meet X7R requirements. An additional desirable property is a lower Curie point temperature that leads to a low loss tangent, which may be less than 5%.

The following examples illustrate the favorable properties in dielectrics prepared according to the present invention, and the capacitors incorporating the dielectrics.

### EXAMPLES 1- 4

Barium titanate compositions with 0%, 5%, 10% and 25% barium titanate replaced by barium zirconate were prepared according to the formulas disclosed in **Table 1**. The compositions were spin-coated on to the drum side of copper foils. After each coat, the films were pre-baked at temperatures at 250°C for 2-10 minutes on a hot plate in air. The coating/pre-baking process was repeated five times. The coated copper foils were annealed at 900°C for 30 minutes under a partial pressure of oxygen of approximately 10⁻¹¹ atmospheres (1.01 x 10⁻⁶ Pa). The dielectrics were then re-oxidized by placing the foil in a vacuum chamber under an atmosphere of approximately 10⁻⁵ Torr (1.33 x 10⁻³ Pa) of oxygen at 550°C for 30 minutes. This condition was chosen to avoid significant oxidation of the copper foil while still providing oxygen for re-oxidation of the dielectric. After re-oxidation, 200 µm diameter top platinum electrodes were sputtered on to the dielectric surfaces and the permittivity (dielectric constant) and loss factor (dissipation factor) as a function of bias and permittivity as a function of temperature were measured.

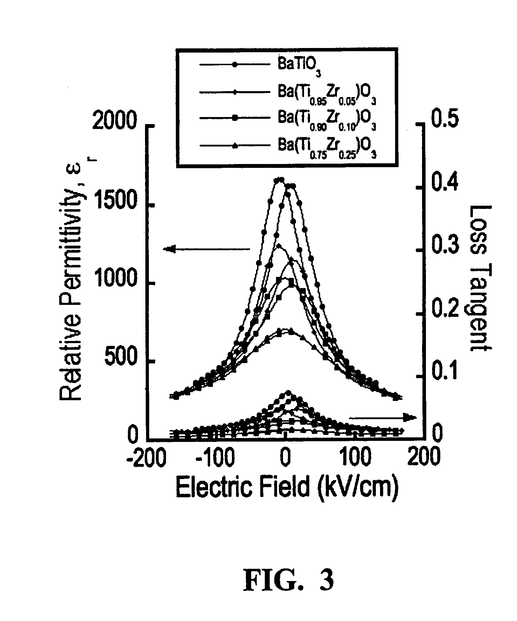

**FIG. 3** shows the permittivity and loss tangent as a function of increasing and decreasing electric field for barium titanate and various barium titanate zirconate compositions. The compositions with equal to or less than 10% barium zirconate show high dielectric constants of greater than 1000 and the hysteresis behavior normally associated with ferroelectric materials. Loss tangents of these materials also fall with increasing zirconium level.

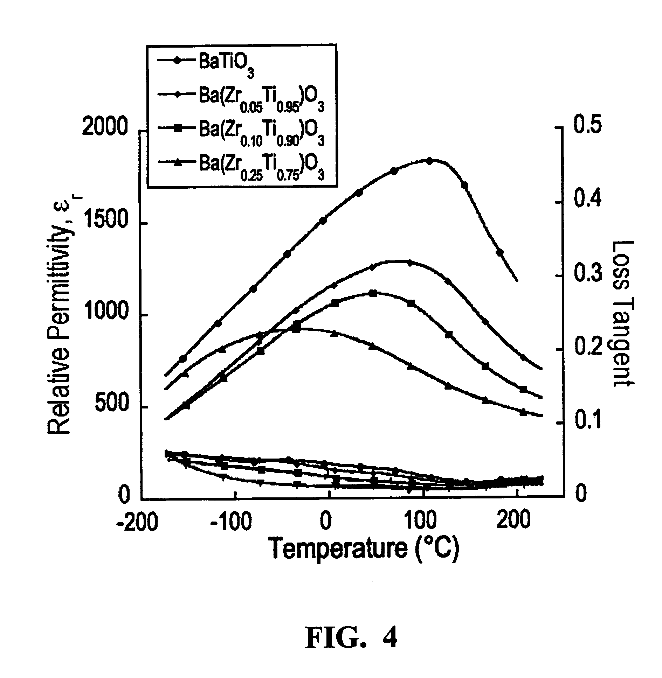

**FIG. 4** shows the permittivity of barium titanate and the various barium titanate zirconate compositions versus temperature. The Curie point of the dielectric is shifted to lower temperatures with increasing zirconium content. The 25% barium zirconate composition has its Curie point below room temperature and is therefore, confirmed to be para-electric at room temperature. Increasing zirconium levels also flattens the response of capacitance with temperature and reduces the loss factor.

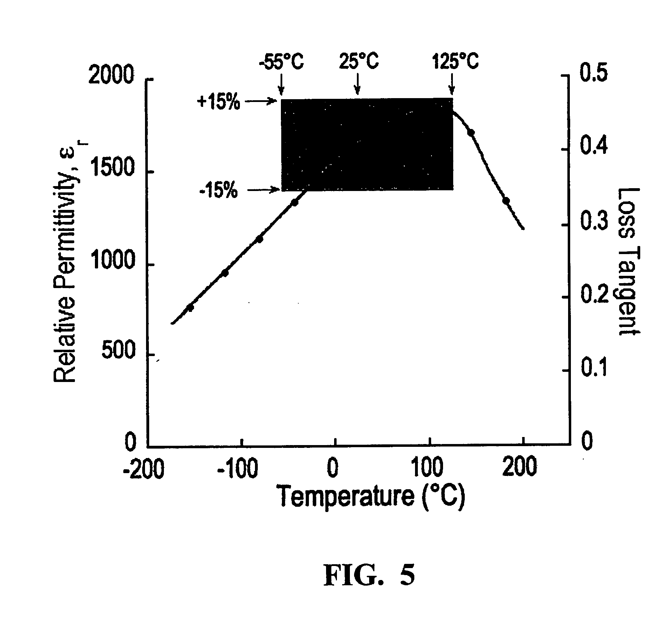

**FIG. 5** shows the permittivity of pure barium titanate versus temperature and the X7R region for this composition. It is observed the permittivity and hence the capacitance varies considerably over the temperature range of -55°C to 125°C.

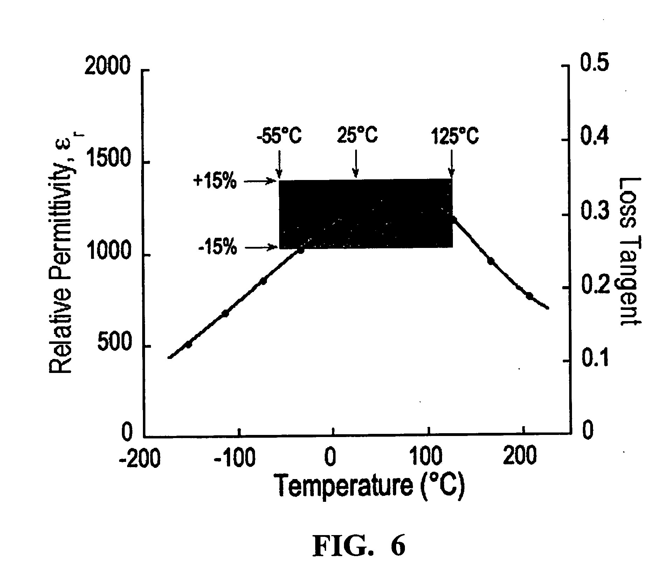

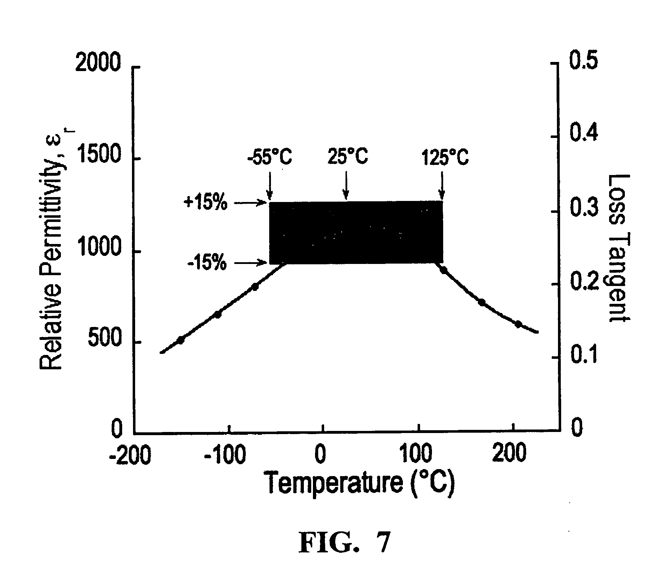

**FIGs. 6** and **7** show the permittivity versus temperature of 95% barium 5% barium zirconate and 90% barium titanate 10% barium zirconate respectively. The X7R regions are also plotted for each composition. It is observed that increased zirconium levels reduce the magnitude of permittivity (capacitance) change within the X7R temperature region and the Curie peak moves closer to the center of the X7R region. From the data, approximately 7.5% barium zirconate will better satisfy the X7R requirement.

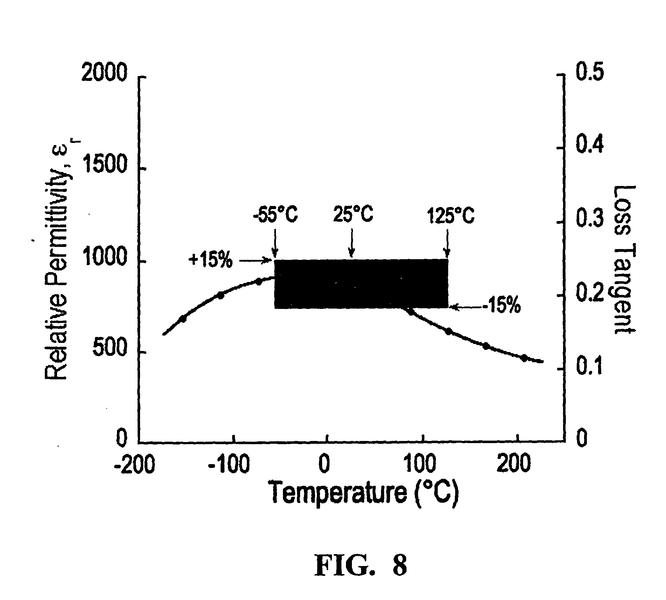

**FIG. 8** shows the permittivity versus temperature for 75% barium titanate 25% barium zirconate along with the X7R region for this composition. It is clear that the Curie point has been reduced beyond that which is needed for X7R requirements.

### EXAMPLES 5 - 8

Barium titanate compositions with 0%, 5%, 10% and 25% barium titanate replaced by barium stannate were prepared according to the formulas disclosed in **Table 2**. The compositions were spin-coated on to the drum side of copper foils. After each coat, the films were pre-baked at temperatures at 250°C for 2-10 minutes on a hot plate in air. The coating/pre-baking process was repeated five times. The coated copper foils were annealed at 900°C for 30 minutes under a partial pressure of oxygen of approximately 10⁻¹¹ atmospheres (1.01 x 10⁻⁶ Pa). The dielectrics were then re-oxidized by placing the foil in a vacuum chamber under an atmosphere of approximately 10⁻⁵ Torr (1.33 x 10⁻³ Pa) of oxygen at 550°C for 30 minutes. This condition was chosen to avoid significant oxidation of the copper foil while still providing oxygen for re-oxidation of the dielectric. After re-oxidation, 200 µm diameter top platinum electrodes were sputtered on to the dielectric surfaces and the permittivity (dielectric constant) and loss factor (dissipation factor) as a function of bias and permittivity as a function of temperature were measured.

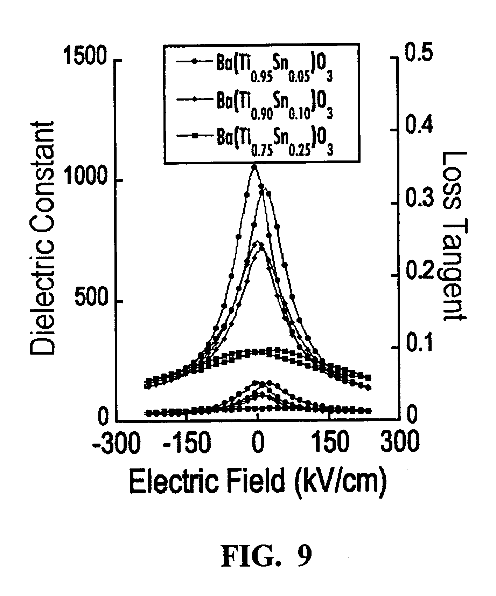

**FIG. 9** shows the permittivity and loss tangent as a function of increasing and decreasing electric field for the various barium titanate stannate compositions. The compositions with equal to or less than 10% barium stannate show high dielectric constants of greater than 700 and the hysteresis behavior normally associated with ferro-electric materials. Loss tangents of these materials also fall with increasing tin level.

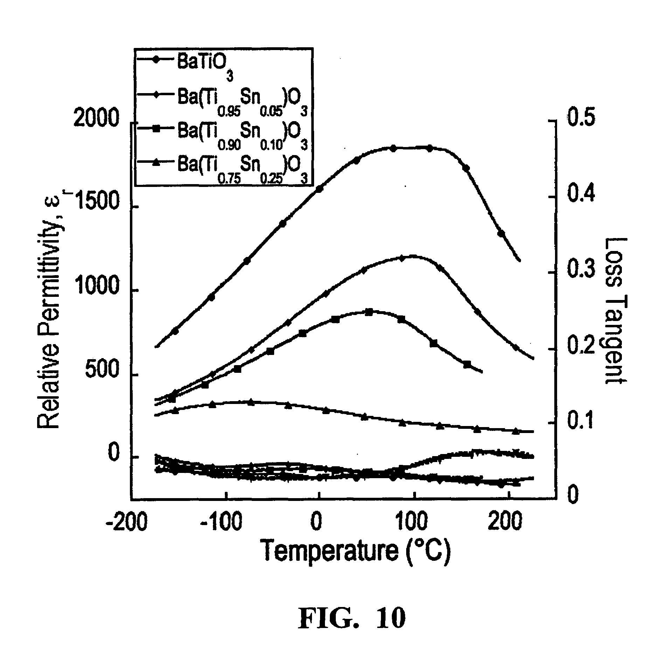

**FIG. 10** shows the permittivity of pure barium titanate and the various barium titanate stannate compositions versus temperature. The Curie point of the dielectric is shifted to lower temperatures with increasing tin content. The 25% barium stannate composition has its Curie point below room temperature and is therefore, confirmed to be para-electric at room temperature. Increasing tin levels also flattens the response of capacitance with temperature and reduces the loss factor.

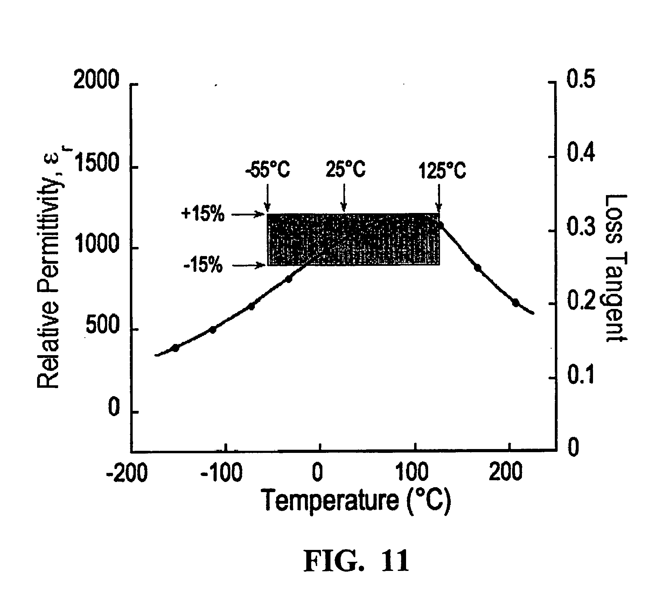

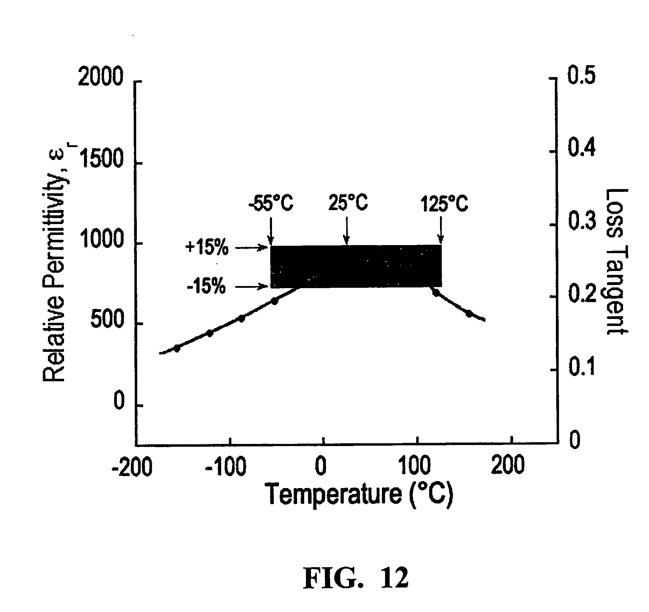

**FIGs. 11** and **12** show the permittivity versus temperature of 95% barium 5% barium stannate and 90% barium titanate 10% barium stannate respectively. The X7R regions are also plotted for each composition. It is observed that increased tin levels reduce the magnitude of permittivity (capacitance) change within the X7R temperature region and the Curie peak moves closer to the center of the X7R region. As with the zirconium examples, X7R requirements may be better satisfied by a composition with between 5 and 10% barium stannate.

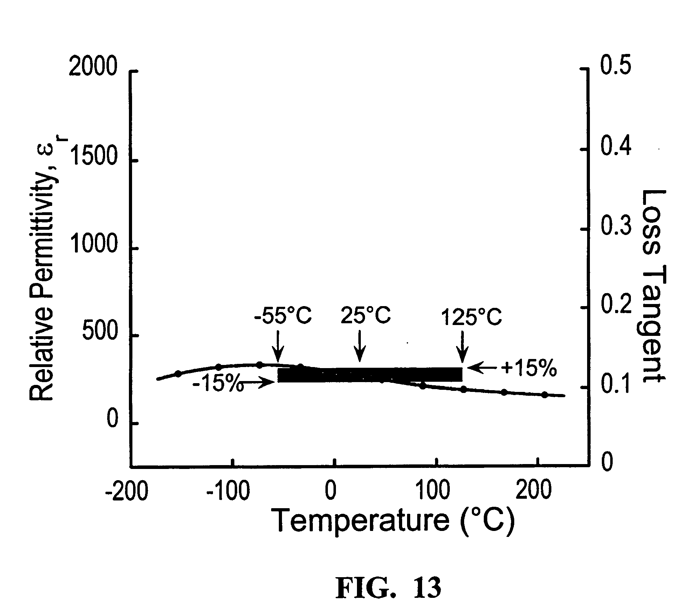

**FIG. 13** shows the permittivity versus temperature for 75% barium titanate 25% barium stannate along with the X7R region for this composition. It is clear that the Curie point has been reduced beyond that which is needed for X7R requirements.

### EXAMPLES 9-12

Barium titanate compositions with 0%, 5%, 10% and 25% barium titanate replaced by barium hafnate were prepared according to the formulas disclosed in **Table 3.** The compositions were spin-coated on to the drum side of copper foils. After each coat, the films were pre-baked at temperatures at 250°C for 2-10 minutes on a hot plate in air. The coating/pre-baking process was repeated five times. The coated copper foils were annealed at 900°C for 30 minutes under a partial pressure of oxygen of approximately 10⁻¹¹ atmospheres (1.01 x 10⁻⁶ Pa). The dielectrics were then re-oxidized by placing the foil in a vacuum chamber under an atmosphere of approximately 10⁻⁵ Torr (1.33 x 10⁻³ Pa) of oxygen at 550°C for 30 minutes. This condition was chosen to avoid significant oxidation of the copper foil while still providing oxygen for re-oxidation of the dielectric. After re-oxidation, top 200 µm diameter platinum electrodes were sputtered on to the dielectric surfaces and the permittivity (dielectric constant) and loss factor (dissipation factor) as a function of bias and capacitance as a function of temperature were measured.

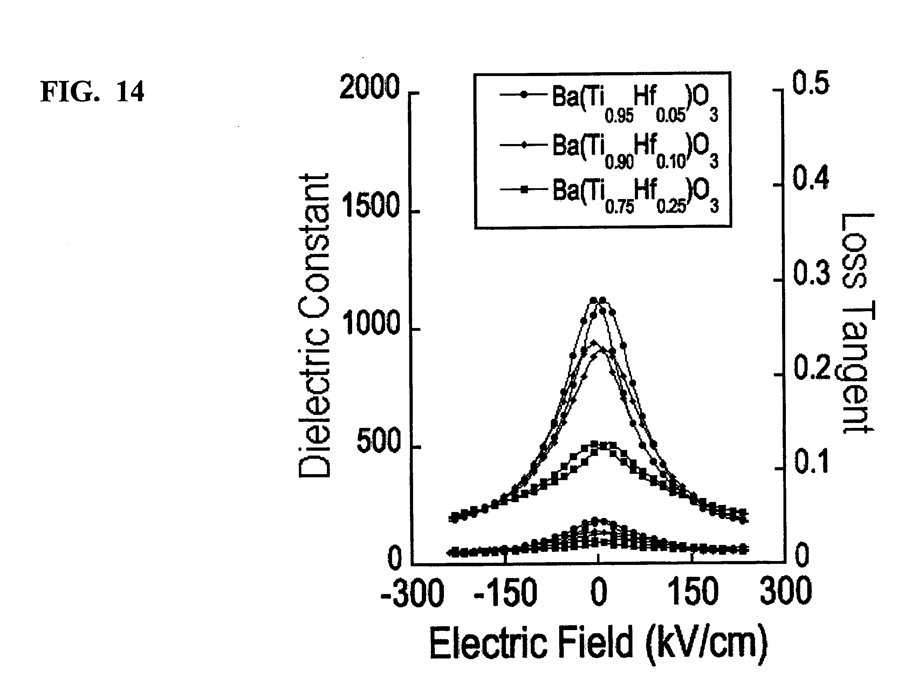

**FIG. 14** shows the permittivity and loss tangent as a function of increasing and decreasing electric field for the various barium titanate hafnate compositions. The compositions with equal to or less than 10% barium hafnate show high dielectric constants of greater than 800 and the hysteresis behavior normally associated with ferro-electric materials. Loss tangents of these materials also fall with increasing hafnium level.

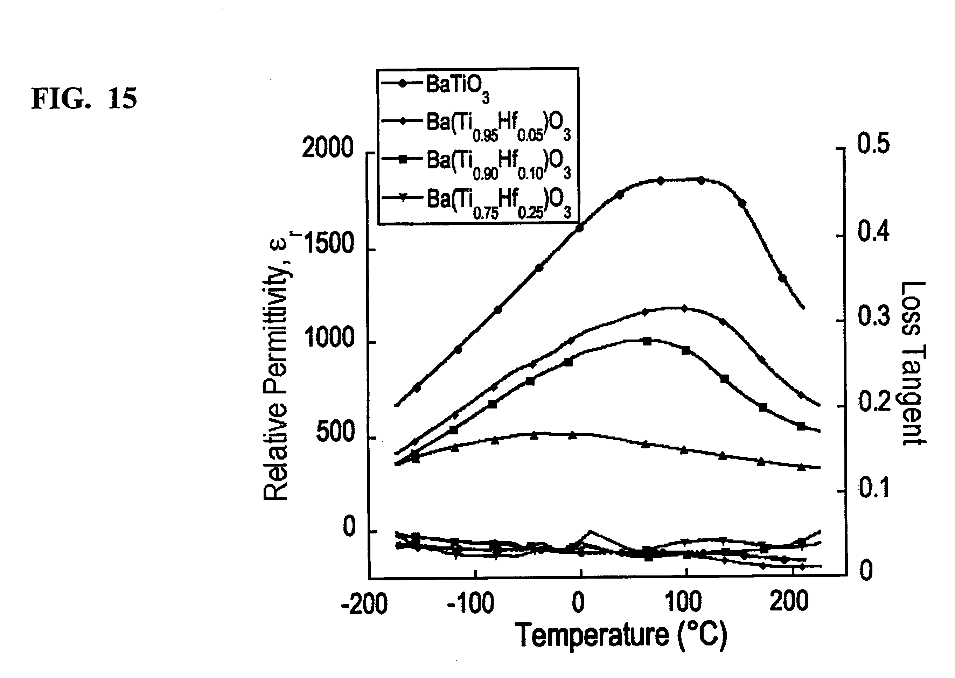

**FIG. 15** shows the permittivity of pure barium titanate and the various barium titanate hafnate compositions versus temperature. The Curie point of the dielectric is shifted to lower temperatures with increasing hafnium content. The 25% barium hafnate composition has its Curie point below room temperature and is therefore, confirmed to be para-electric at room temperature. Increasing hafnium levels also flattens the response of capacitance with temperature.

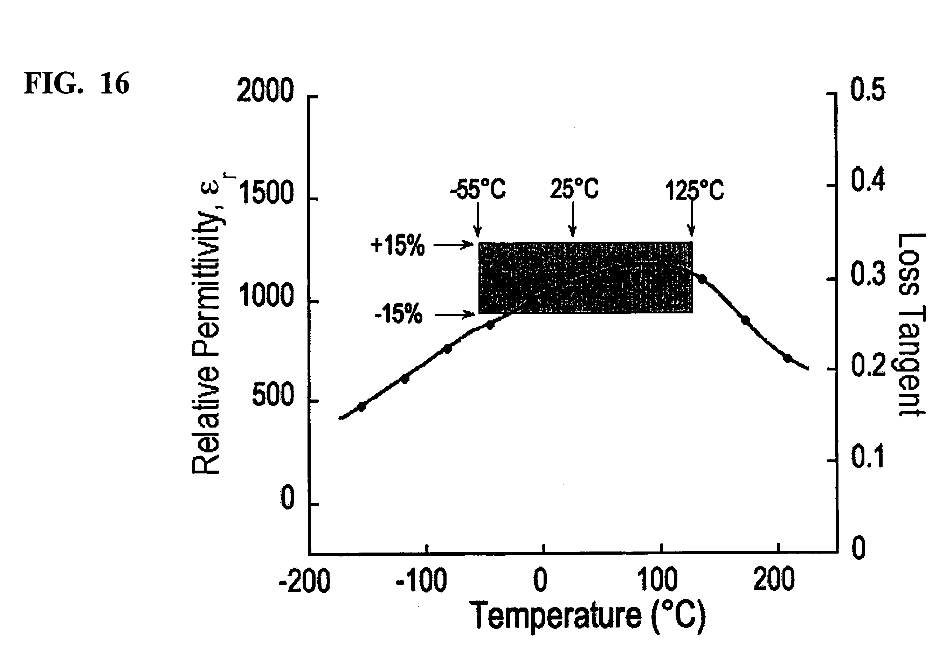

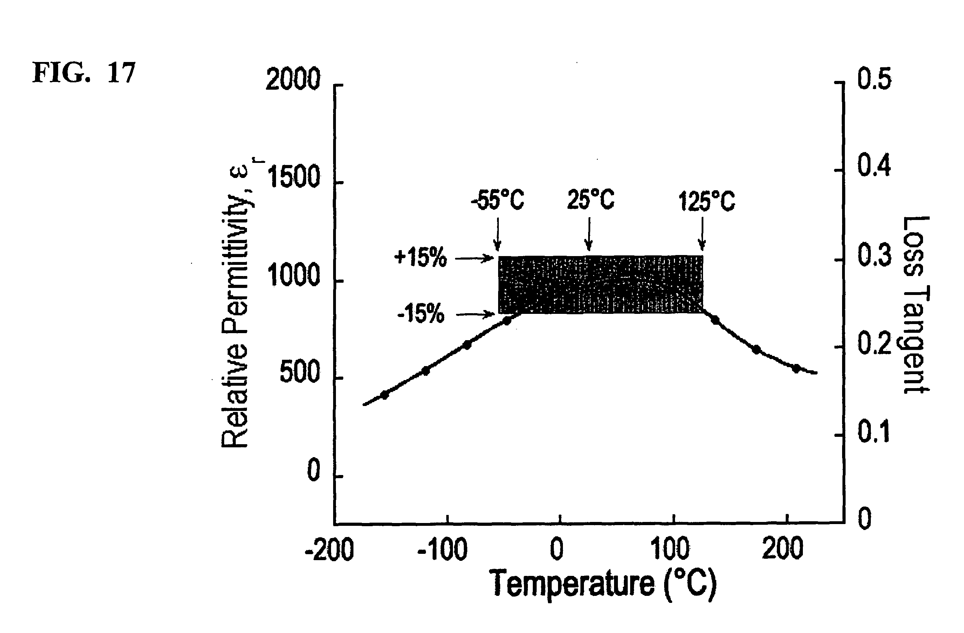

**FIGs. 16** and **17** show the permittivity versus temperature of 95% barium 5% barium hafnate and 90% barium titanate 10% barium hafnate respectively. The X7R regions are also plotted for each composition. It is observed that increased hafnate levels reduce the magnitude of permittivity (capacitance) change within the X7R temperature region and the Curie peak moves closer to the center of the X7R region. As with the zirconium examples, X7R requirements may be better satisfied by a composition with between 5 and 10% barium hafnate.

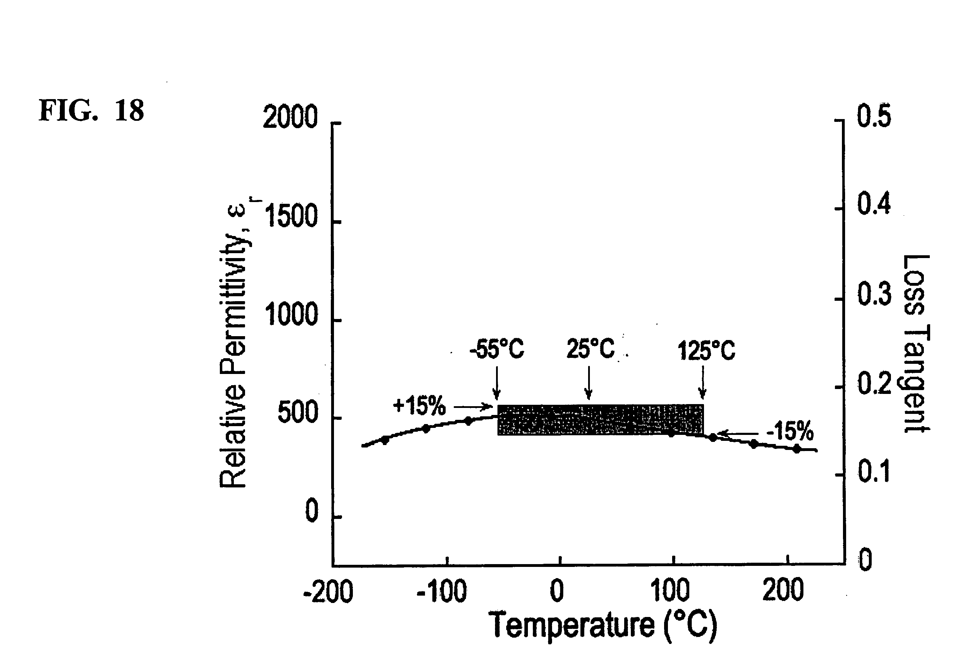

**FIG. 18** shows the permittivity versus temperature for 75% barium titanate 25% barium hafnate along with the X7R region for this composition. It is clear that the Curie point has been reduced beyond that which is needed for X7R requirements.

**Table 1**

| | 0% | 5% | 10% | 25% |
|---|---|---|---|---|
| Barium Acetate | 2.55g | 2.55g | 2.55g | 2.55g |
| Acetic Acid | 21.7g | 21.7g | 21.7g | 21.7g |
| Titanium Isopropoxide | 2.84g | 2.70g | 2.56g | 2.13g |
| 2,4 Pentanedione | 2.03g | 2.03g | 2.03g | 2.03g |
| Diethanolamine | 0.27g | 0.27g | 0.27g | 0.27g |
| Zirconium Propoxide (70wt% in Propanol) | Og | 0.23g | 0.47g | 1.15g |

**Table 2**

| | 0% | 5% | 10% | 25% |
|---|---|---|---|---|
| Barium Acetate | 2.55g | 2.55g | 2.55g | 2.55g |
| Acetic Acid | 21.7g | 21.7g | 21.7g | 21.7g |
| Titanium Isopropoxide | 2.84g | 2.70g | 2.56g | 2.13g |
| 2,4 Pentanedione | 2.03g | 2.03g | 2.03g | 2.03g |
| Diethanolamine | 0.27g | 0.27g | 0.27g | 0.27g |
| Tin Butoxide | Og | 0.20g | 0.41g | 1.03g |

**Table 3**

| | 0% | 5% | 10% | 25% |
|---|---|---|---|---|
| Barium Acetate | 2.55g | 2.55g | 2.55g | 2.55g |
| Acetic Acid | 21.7g | 21.7g | 21.7g | 21.7g |
| Titanium Isopropoxide | 2.84g | 2.70g | 2.56g | 2.13g |
| 2,4 Pentanedione | 2.03g | 2.03g | 2.03g | 2.03g |
| Diethanolamine | 0.27g | 0.27g | 0.27g | 0.27g |
| Tetrakis(1-methoxy 2-methyl 2-propoxy)hafnium | 0g | 0.29g | 0.59g | 1.48g |

## Claims

1. A barium titanate-based dielectric precursor solution comprising barium acetate, a titanium source and a B-site cation source.

2. The barium titanate-based dielectric precursor solution of claim 1 wherein said titanium source is selected from titanium isopropoxide, titanium butoxide, and mixtures thereof.

3. The barium titanate-based dielectric precursor solution of claim 1 or claim 2 wherein said B-site cation source is selected from zirconium propoxide, tin butoxide, tetrakis(1-methoxy-2-methyl-2-propoxy)hafnium(1V), and mixtures thereof.

4. The solution of claim 3 wherein said zirconium propoxide is partially or fully replaced by one or more zirconium sources selected from zirconium (IV) t-butoxide, zirconium acetate, tetrakis (ethymethylamido) zirconium, tetrakis (triethanolaminato) zirconium, tetrakis (dimethylamido) zirconium (IV), zirconium (IV) acetylacetonate, and zirconium (IV) isopropoxide isopropanol.

5. The solution of claim 3 wherein said tin butoxide propoxide is partially or fully replaced by one or more tin sources selected from tin (IV) isopropoxide, tin (II) 2-ethylhexanoate, tetrabutlytin, tetramethyltin and tetraphenyltin.

6. The solution of claim 3 wherein said tetrakis(1-methoxy-2-methyl-2-propoxy)hafnium(IV) is partially or fully replaced by one or more hafnium sources selected from hafnium tert-butoxide, tetrakis (ethymethylamido) hafnium (IV), and tetrakis (dimethylamido) hafnium (IV).

7. A barium titanate dielectric composition for fired on foil capacitors comprising barium titanate and one or more barium-based compounds selected from barium zirconate, barium stannate and barium hafnate.

8. The dielectric composition of claim 7 wherein said barium titanate is present in the range of 90-95 mole percent based on total composition and wherein said barium-based compounds are present in the range of 5-10 mole percent, based on total composition.

9. A method of making a capacitor, comprising:
providing a bare metallic foil;
forming a dielectric over the bare metallic foil, wherein forming the dielectric comprises: providing a dielectric precursor solution comprising barium acetate, at least one of titanium isopropoxide and titanium butoxide, and a B-site cation source selected from zirconium propoxide, tin butoxide, tetrakis(1-methoxy-2-methyl-2-propoxy)hafnium(IV), and mixtures thereof;
forming a dielectric layer over the foil;
annealing the dielectric layer; wherein annealing comprises:
annealing at a temperature in the range of about 800-1050°C and annealing comprises annealing in an environment having an oxygen partial pressure of less than about 10⁻⁸ atmospheres (1.0 x 10⁻³ Pa);
re-oxygenating the dielectric resulting from the annealing; and
forming a conductive layer over the dielectric, wherein the metallic foil, the dielectric, and the conductive layer form the capacitor.

10. A capacitor obtainable by the method of claim 9.
